# EUROPÄISCHE PATENTANMELDUNG

(11) **EP 2 439 829 A2**
(43) Veröffentlichungstag der Anmeldung: **11.04.2012**
(21) Anmeldenummer: 11179236.2
(22) Anmeldetag: 30.08.2011
(51) Int. Cl.: H02H 7/20, H01L 31/02

(54) **Anordnung zum sicheren Außerbetriebsetzen von Photovoltaikanlagen**

(30) Priorität: 08.10.2010 DE 102010047935; 22.10.2010 DE 102010049293
(71) Anmelder: VWL Umweltcentrum für Haustechnik, 09366 Gablenz (DE)
(72) Erfinder: John, Karl, 09387 Jahnsdorf (DE); Leitl, Harald, 09353 Oberlungwitz (DE)
(74) Vertreter: Kruspig, Volkmar

(57) **Zusammenfassung**

Die Erfindung betrifft eine Anordnung zum sicheren Außerbetriebssetzen von Photovoltaikanlagen, welche mehrere zu mindestens einem String verschaltete Module aufweisen, wobei der mindestens eine String durch eine steuerbare Schalteinrichtung in einen Kurzschlusszustand überführbar ist. Erfindungsgemäß ist die steuerbare Schalteinrichtung als stromtragfähiger Halbleiterschalter, insbesondere Thyristor ausgebildet, an dessen Steuereingang ein Ausschaltsignal anlegbar ist, wobei zum Wiederinbetriebsetzen dem stromtragfähigen Halbleiterschalter eine weitere Schalteinrichtung, insbesondere ein Transistor, parallel geschaltet ist derart, dass durch kurzzeitige Übernahme des Laststroms des stromtragfähigen Halbleiterschalters dieser zurückgesetzt wird.

## Beschreibung

Die Erfindung betrifft eine Anordnung zum sicheren Außerbetriebsetzen von Photovoltaikanlagen, welche mehrere zu mindestens einem String verschaltete Module aufweisen, wobei der mindestens eine String durch eine steuerbare Schalteinrichtung in einen Kurzschlusszustand überführbar ist, gemäß Patentanspruch 1.

Aus der EP 1 720 241 A2 ist ein Photovoltaikgenerator mit einem Thermoschalter vorbekannt, der beim Ansprechen eine Reduzierung der Leistung des Photovoltaikgenerators bewirkt. Der Thermoschalter schließt beim Ansprechen die Modul-Anschlusspole kurz. Hierdurch wird der Photovoltaikgenerator im Brandfall in einen für die löschenden Personen ungefährlichen Betriebszustand überführt. Unter dem Begriff Thermoschalter wird nach EP 1 720 241 A2 jedes Schaltelement verstanden, welches bei Erreichen einer vorgebbaren oder vorgegebenen Temperatur oder eines anderen feueranzeigenden Parameters einen Schaltvorgang initiiert, der mittelbar oder unmittelbar zum Schließen oder Öffnen einer elektrischen Verbindung führt. Der Thermoschalter kann in, aber auch außerhalb des Modulgehäuses angeordnet werden, um das Ansprechverhalten zu optimieren. Zur gewünschten elektrischen Überbrückung im thermischen Gefahrenfall wird ein Strang einer Photovoltaikanlage mit dem vorerwähnten Thermoschalter versehen und überbrückt.

Nachteilig bei der Anordnung nach EP 1 720 241 A2 ist die Notwendigkeit des Erkennens eines eindeutigen Brandzustands, insbesondere durch entsprechend hohe Temperaturen. Eine manuelle Bedienung ist ebenso wenig möglich, wie bei einer beabsichtigten Brandlöschung nicht erkennbar ist, ob sich die betreffende Photovoltaikanlage tatsächlich in einem spannungsfreien Zustand befindet.

Aus der US 2002/0014262 A1 ist eine Photovoltaikanlage mit einem Leistungsüberwachungssystem offenbart, wobei im jeweiligen String der Anlage nicht nur ein Lasttrenner, sondern auch eine Kurzschlusseinrichtung befindlich ist.

Die Kurzschlusseinrichtung wird über eine Sensorik betrieben, die bevorzugt ebenfalls temperaturabhängig den Kurzschlussfall auslöst. Damit sind auch bei dieser Lösung des Standes der Technik die voranstehend geschilderten Nachteile gegeben.

Bekannte Lasttrenner sind in der Lage, die Gleichspannung der Photovoltaikzellen vom nachgeordneten Wechselrichter abzutrennen. Der Nachteil beim Einsatz von Lasttrennern besteht darin, dass die hohe Gleichspannung mit bis zu 1000 V auf der Anlage stehen bleibt und weiterhin eine Gefährdung darstellt.

Bekannterweise muss für den Fall, dass die gesamte Photovoltaikanlage unter 60 V Gleichspannung zu bringen ist, ein Kurzschluss der Module erfolgen. Hierzu existieren Systeme, bei denen jedes Solarzellenmodul mit einer Schaltbox ausgerüstet wird. Diese schließen jedes Modul beim Betätigen eines Tasters dann kurz. Sowohl der konstruktive als auch der schaltungstechnische Aufwand ist bei einer solchen Lösung erheblich. Die Möglichkeit einer Nachrüstung ist nicht gegeben.

Aus der DE 10 2005 018 173 B4 ist eine Schalteinrichtung zum sicheren Betriebsunterbrechen von Photovoltaikanlagen bekannt, wobei dort die Aufgabe gelöst wird, unabhängig davon, ob bereits eine Leitungsstörung vorliegt oder nicht, in gefährlichen Situationen eine umgehende Abschaltung der Photovoltaikanlage zu ermöglichen. Die dortige Schalteinrichtung weist eine durch ein Steuersignal auslösbare Schutzeinrichtung auf, die das Photovoltaik-Generatorfeld in einen sicheren Arbeitspunkt überführt, der keine weitere Energieabgabe in das Gebäude ermöglicht. Das Generatorfeld verbleibt so lange im sicheren Arbeitspunkt, bis es durch Eingriff an der Schutzeinrichtung wieder aktiviert wird. Die Schutzeinrichtung ist hierfür über eine Steuerleitung mit einer entfernt von der Schutzeinrichtung angeordneten Auslöseeinrichtung verbunden, über die die Schutzeinrichtung aktivierbar ist. Die Auslöseeinrichtung ist bei einer Ausführungsform ein manuell auslösbarer Schalter in Form eines Not- oder Schlüsselschalters.

Zum Kurzschließen wird nach DE 10 2005 018 173 B4 ein Thyristor gezündet, der dann den Strom aus dem Solargenerator übernimmt. Damit bleiben die Ausgangsklemmen strom- und spannungsfrei, bis der Generatorstrom nach Einbruch der Dunkelheit zu Null wird. Es muss also bis zum Wiederinbetriebnehmen ein Tag-/Nacht-Zyklus abgewartet werden.

Die DE 40 41 672 A1 zeigt eine Überwachungseinrichtung für einen Gleichstromkreis sowie eine damit ausgerüstete photovoltaische Energiegewinnungsanlage.

Bei der schaltungstechnischen Ausführung ist ein bistabiles Relais mit einem Schalter als Kurzschließer vorhanden. Diesem Schalter ist ein weiterer, Handschalter parallel geschaltet, um einen zweiten Kurzschlussstromkreis zu bilden, derart, dass nach Schließen des ersten Schalters das bistabile Relais wieder geöffnet werden kann. Es wird diesbezüglich explizit von einer Handbetätigung des Relais ausgegangen. Um die Anlage nach DE 40 41 672 A1 wieder in den normalen Betriebszustand zu bringen, muss zunächst der Handschalter geöffnet werden, wodurch dann der zweite Kurschlussstromkreis unterbrochen und der erzeugte Generatorstrom wiederum dem Wechselrichter zugeführt wird. Es ist daher der Handschalter unter Last zu öffnen und entsprechend zu dimensionieren.

Aus dem Vorgenannten ist es daher Aufgabe der Erfindung, eine weiterentwickelte Anordnung zum sicheren Außerbetriebsetzen von Photovoltaikanlagen anzugeben, wobei die Photovoltaikanlagen mehrere zu mindestens einem String verschaltete Module aufweisen, wobei der mindestens eine String durch eine steuerbare Schalteinrichtung in einen Kurzschlusszustand überführ- sowie jederzeit aktivierbar ist. Mit der erfindungsgemäßen Lösung soll auch eine Nachrüstbarkeit vorhandener Anlagen in leichter Weise möglich werden. Darüber hinaus soll für den Bediener bzw. den löschenden Feuerwehrmann erkennbar sein, ob die Anlage tatsächlich stromlos geschaltet ist, um beispielsweise einen in elektrischer Hinsicht risikoarmen Löschangriff durchzuführen.

Die Lösung der Aufgabe der Erfindung erfolgt durch eine Anordnung gemäß der Merkmalskombination nach Patentanspruch 1, wobei die Unteransprüche mindestens zweckmäßige Ausgestaltungen und Weiterbildungen beinhalten.

Es wird demnach von einer Anordnung zum sicheren Außerbetriebsetzen von Photovoltaikanlagen ausgegangen, welche mehrere zu mindestens einem Strang verschaltete Module aufweisen, wobei der mindestens eine Strang oder String durch eine steuerbare Schalteinrichtung in einen Kurzschlusszustand überführbar ist.

Die steuerbare Schalteinrichtung ist als stromtragfähiger Halbleiterschalter, insbesondere als Thyristor ausgebildet, an dessen Steuereingang ein Ausschaltsignal anlegbar ist.

Zum Wiederinbetriebsetzen ist dem stromtragfähigen Halbleiterschalter eine weitere Schalteinrichtung, insbesondere ausgeführt als Transistor, parallel geschaltet derart, dass durch eine kurzzeitige Übernahme des Laststroms des stromtragfähigen Halbleiterschalters dieser zurücksetzbar ist.

Bei einer Ausführungsform der Erfindung wird über einen Spannungsteiler ein Kondensator aus der Photovoltaikanlage mit Energie versorgt, wobei der Kondensator mit dem Steuereingang des insbesondere Thyristors verbindbar ist, um den Kurzschlusszustand, z.B. im Fall einer Gefahr, zu bewirken bzw. zu erreichen.

Auch ist eine Fernschalteinrichtung vorhanden, welche eine netzunabhängige Stromversorgung und einen Not-Aus-Taster besitzt. Weiterhin ist die Fernschalteinrichtung galvanisch getrennt mit dem Steuereingang des stromtragfähigen Halbleiterschalters verbunden. Über eine solche Schalteinrichtung können auch mehrere Photovoltaikanlagen mit entsprechender steuerbarer Schalteinrichtung im Gefahrenfall außer Betrieb gesetzt werden.

Für die galvanische Trennung ist beispielsweise ein Optokoppler vorgesehen, der ausgangsseitig mit dem Steuereingang des stromtragfähigen Halbleiterschalters in Verbindung steht.

Die netzunabhängige Stromversorgung für die Fernschalteinrichtung kann eine Solarzelle und einen diesbezüglich mit der Solarzelle in Verbindung stehenden Speicherkondensator umfassen.

Bei einer bevorzugten Ausführungsform weist die Fernschalteinrichtung einen Spannungsmesser auf, welcher über einen Spannungsteiler mit den Stringpolen in Verbindung steht. Nach Betätigen des Not-Aus-Tasters der Fernschalteinrichtung ist dann deutlich erkennbar, ob tatsächlich die Photovoltaikanlage außer Betrieb gesetzt wurde.

Die Elemente der Fernschalteinrichtung sind bevorzugt in einem gemeinsamen Gehäuse integriert.

Ergänzend kann zwischen den jeweiligen Photovoltaikanlagen und den jeweils zugehörigen Wechselrichtern die Anordnung von Lasttrennern vorgenommen werden.

Erfindungsgemäß ist die weitere Schalteinrichtung als Transistor ausgebildet, an dessen Basis eine Spannung zum Zurücksetzen des stromtragfähigen Halbleiterschalters angelegt wird, wobei diese Spannung aus einem Kondensator zur Verfügung gestellt ist, welcher über eine spannungsbegrenzende Diode sowie einen Spannungsteiler und eine Freilaufdiode über die Stringpole geladen wird.

Die erfindungsgemäße Lösung wendet die an sich bekannte Kurzschlusstechnik an, jedoch nicht am einzelnen Modul, sondern am String der Photovoltaikanlage. Hierdurch kann die gesamte Anlage spannungsfrei geschaltet und im Brandfall gefahrlos gelöscht werden. Ein Lasttrenner sorgt zusätzlich für die notwendige Trennung vom Wechselrichter, was Vorteile bei der Wartung der Anlage nach sich zieht.

Die Erfindung soll nachstehend anhand eines Ausführungsbeispiels sowie unter Zuhilfenahme von Figuren näher erläutert werden.

Hierbei zeigen:
- Fig. 1: ein Blockschaltbild der erfindungsgemäßen Anordnung zum sicheren Außerbetriebsetzen von Photovoltaikanlagen;
- Fig. 2: eine erste Ausführungsform der Anordnung mit einem Thyristor als stromtragfähigen Halbleiterschalter sowie Fernschalteinrichtung und Kurzschlussschaltung und
- Fig. 3: eine zweite Ausführungsform der Anordnung mit Not-Aus und Resetauslösung allein über den Fernschalter.

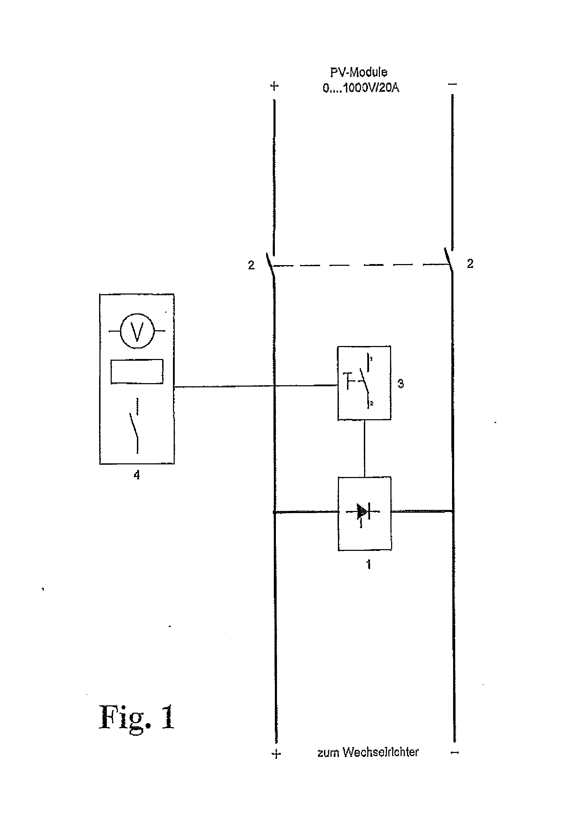

Wie aus der Darstellung nach Fig. 1 entnommen werden kann, ist zwischen den Gleichspannungspolen eines Strings, der eine Zusammenschaltung mehrerer PV-Module darstellt, ein stromtragfähiger Halbleiterschalter 1 befindlich.

Der stromtragfähige Halbleiterschalter 1 steht mit einer Ansteuerelektronik 3 in Verbindung, die wiederum von einer Not-Aus-Tasteranordnung mit Spannungsanzeige 4 aktiviert wird. Zwischen den in der Fig. 1 im einzelnen nicht gezeigten PV-Modulen mit ebenfalls nicht gezeigten Wechselrichtern ist noch ein Lasttrenner 2 geschaltet. Wenn der Not-Aus-Taster 4 betätigt wird, wird die Schutzfunktion unter Rückgriff auf die Ansteuerelektronik 3 ausgelöst und der Halbleiterschalter 1 in den Kurzschlusszustand überführt. Hierdurch wird die Spannung an der diesbezüglichen Photovoltaikanlage auf einen ungefährlichen Wert unter 60 V DC gebracht.

Die Schutzfunktion kann über den Lasttrenner 2 manuell zurückgestellt werden. Der Lasttrenner 2 ermöglichen auch eine Trennung der Anlage vom Wechselrichter im Wartungsfall.

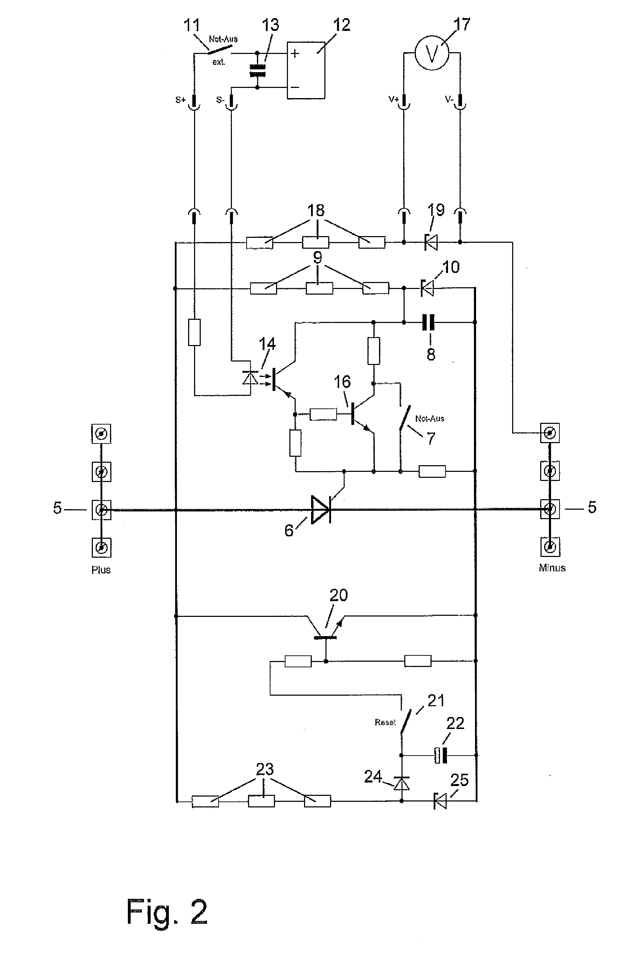

Die Ansteuerelektronik 3 sowie der Not-Aus-Taster 4 mit Spannungsanzeige sowie die weiteren Komponenten der erfindungsgemäßen Anordnung sollen mit Rückgriff auf die Fig. 2 näher erläutert werden.
Zwischen den Polen 5 des jeweiligen Strings befindet sich ein Thyristor 6 als stromtragfähiger Halbleiterschalter. Der Steuereingang des Thyristors 6 steht mit einem Not-Aus-Schalter 7 in elektrischer Verbindung.

Um den Thyristor 6 in den Kurzschlusszustand zu überführen, wird der Not-Aus-Taster 7 geschlossen. In diesem Fall wird in dem Kondensator 8 gespeicherte Energie auf das Gate, d.h. den Steuereingang des Thyristors 6 geführt. Der Kondensator 8 ist über einen Spannungsteiler 9 und eine Zenerdiode 10 mit Energie versorgt, wobei der Spannungsteiler 9 mit der Zenerdiode 10 eine Reihenschaltung bildet und diesbezüglich zwischen den Strangpolen 5 angeordnet ist.

Eine weitere Möglichkeit des Aktivierens der Anordnung zum sicheren Außerbetriebssetzen von Photovoltaikanlagen besteht darin, eine Fernschalteinrichtung zu nutzen.

Die Fernschalteinrichtung enthält einen externen Not-Aus-Taster 11, eine netzunabhängige Stromversorgung 12 und eine Speichereinrichtung, insbesondere einen Speicherkondensator 13.

Die netzunabhängige Stromversorgung 12 kann z.B. als Solarzelle ausgebildet sein.

Wird der Not-Aus-Taster 11 betätigt, gelangt galvanisch, über einen Optokoppler 14 getrennt, Energie auf das Gate des Thyristors 6, so dass dieser in den leitfähigen Zustand übergeht. Diesbezüglich steht der Optokoppler 14 ausgangsseitig mit einem Schalttransistor 16 in Verbindung.

Wenn der Thyristor sich im leitenden Zustand befindet, zeigt das Voltmeter 17 keine Spannung an. Hierdurch ist überprüfbar, ob das Außerbetriebsetzen erfolgreich war. Der Spannungsmesser 17 ist über eine Spannungsteileranordnung 18 an den Stringpolen 15 angeschlossen.
Eine Z-Diode 19 übernimmt den Schutz des Voltmeters vor Spannungsspitzen.

Um den Kurzschlusszustand wieder aufzuheben, ist dem Thyristor 6 eine weitere Schalteinrichtung 20, insbesondere ausgeführt als Transistor, parallel geschaltet. Der Transistor 20 ist in der Lage, eine kurzzeitige Übernahme des Laststroms des Thyristors zu realisieren, so dass letzterer zurücksetzbar ist. Die Basis des Transistors 20 steht mit einem Reset-Taster 21 in Verbindung. Über den Reset-Taster 21 wird der Kondensator 22 entladen und der Transistor 20 durchgesteuert. Das Aufladen des Kondensators 22 erfolgt über die Spannungsteileranordnung 23 und die Freilaufdiode 24 in Verbindung mit einer spannungsbegrenzenden Diode 25.

Zum Ausschalten übernimmt also der Transistor 20 kurzzeitig den Laststrom, wenn die Basis des Transistors 20 über den Reset-Schalter 21 angesteuert wird. Der Thyristor 6 geht dann zurück in den Blockierzustand und der Spannungsmesser 17 zeigt die jetzt wieder anliegende volle Strangspannung an.

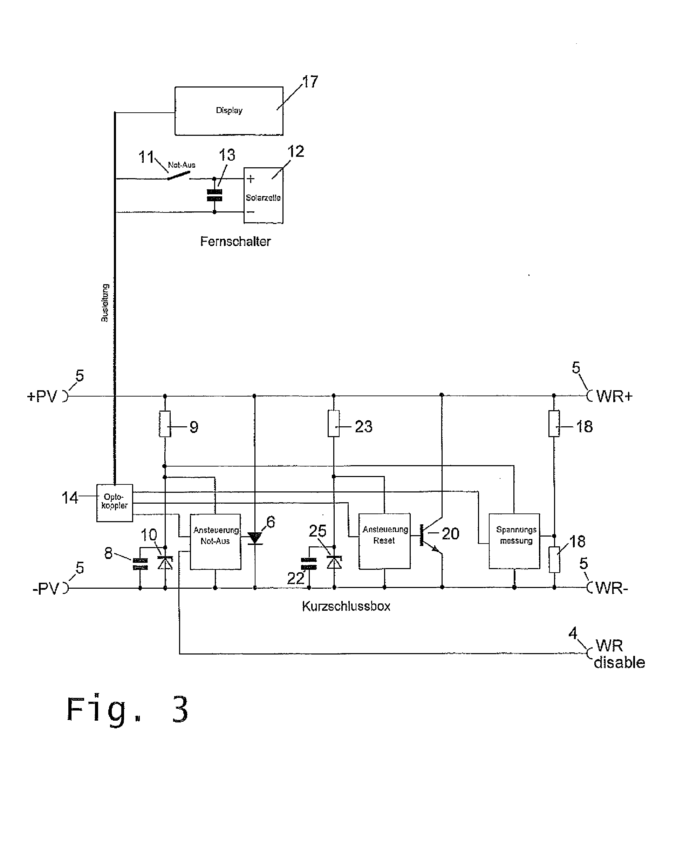

Bei der zweiten Ausführungsform der Erfindung gemäß Fig. 3 wird von einer Schaltungseinrichtung ausgegangen, die im Wesentlichen derjenigen nach Fig. 2 entspricht, wobei für dieselben Schaltungselemente und Bauteile identische Bezugszeichen verwendet wurden.

Wie aus der Fig. 3 ersichtlich, ist kein Not-Aus-Taster 7 wie in der Fig. 2 gezeigt, in der eigentlichen, sogenannten Kurzschlussbox enthalten. Damit können Forderungen von Prüfungsbehörden erfüllt werden, die davon ausgehen, die Kurschlussbox frei von möglicherweise lichtbogenziehenden Schaltelementen auszugestalten.

Bei der Lösung gemäß dem zweiten Ausführungsbeispiel nach Fig. 3 wird die Not-Aus-Schaltung über den Not-Aus-Taster 11 und hierüber ebenso die ResetAuslösung vorgenommen, wobei die diesbezüglichen Schaltbefehle über eine Busleitung übertragen werden. An die Busleitung ist ein bevorzugt LCD-Display 17 anstelle eines klassischen analogen Voltmeters gemäß Ausführungsform nach
Fig. 2 angeschlossen.

Zum Erhalt der mit dem Display 17 anzuzeigenden Spannungswerte ist eine Spannungsmessbaugruppe zur Bereitstellung entsprechender digitaler Daten und deren Übertragung über die Busleitung in der Kurzschlussbox vorhanden. Über ein Signal WR disable am Anschlusspunkt 4 kann bei Auswahl des Wechselrichters die Photovoltaikanlage spannungsfrei geschaltet werden, so dass keine Energie mehr in den Wechselrichter eingetragen wird. Ebenso kann am Anschlusspunkt 4 eine Brandmeldeanlage oder andere Meldeeinrichtungen angeschlossen werden, die die Anlage spannungsfrei schalten.

Gemäß Ausführungsbeispiel nach Fig. 3 ist die steuerbare Schalteinrichtung als Thyristor 6 ausgeführt, an dessen Steuereingang ein Ausschaltsignal anlegbar ist. Weiterhin ist ein Kondensator 8 vorhanden, der aus der Photovoltaikanlage mit Energie versorgt wird, wobei der Kondensator 8 mit dem Steuereingang des Thyristors 6 verbunden ist. Beim Anlegen eines diesbezüglichen Signals über den Not-Aus-Taster 11, galvanisch mittels Optokoppler 14 getrennt, wird der Kurzschlusszustand eingeleitet.

Zum Wiederinbetriebsetzen ist dem stromtragfähigen Halbleiterschalter, d.h. dem Thyristor 6, ein Transistor 20 dergestalt parallel geschaltet, dass durch kurzzeitige Übernahme des Laststroms der Thyristor wieder zurückgesetzt wird. Hierfür ist an die Basis des Transistors 20 eine Reset-Spannung zum Zurücksetzen anlegbar, wobei diese Spannung aus einem weiteren Kondensator 22 zur Verfügung gestellt ist, welche über eine spannungsbegrenzende Diode 25 durch Anschluss an die Stringpole geladen wird. Ergänzend kann eine Freilaufdiode 24 analog der Ausführungsform nach Fig. 2 vorgesehen sein.

Bei einer figürlich nicht dargestellten Ausführungsform besteht die Möglichkeit, das Not-Aus-Signal und/oder das Reset-Signal drahtlos zu übertragen. Hierfür kann der Fernschalter eine integrierte Sendereinheit aufweisen, welche vorzugsweise im sogenannten ISM-Band arbeitet. Die Spannungsversorgung dieser Sendereinrichtung nebst Fernschalter wird über eine separate Solarzelle 12 analog der Ausführungsform nach Fig. 2 oder 3 realisiert. In der Kurzschlussbox ist ein frequenzseitig abgestimmter Empfänger vorgesehen, welcher im Auslösefall ein kodiertes Datentelegramm empfängt, um hiernach den Thyristor 6 zu zünden.

## Patentansprüche

1. Anordnung zum sicheren Außerbetriebsetzen von Photovoltaikanlagen, welche mehrere zu mindestens einem String verschaltete Module aufweisen, wobei der mindestens eine String durch eine steuerbare Schalteinrichtung in einen Kurzschlusszustand überführbar ist, und
die steuerbare Schalteinrichtung als stromtragfähiger Halbleiterschalter, insbesondere Thyristor ausgebildet ist, an dessen Steuereingang ein Ausschaltsignal anlegbar ist, sowie über einen Spannungsteiler ein Kondensator aus der Photovoltaikanlage mit Energie versorgt wird, wobei der Kondensator mit dem Steuereingang des insbesondere Thyristors verbindbar ist, um den Kurzschlusszustand zu erreichen,
**dadurch gekennzeichnet, dass**
zum Wiederinbetriebsetzen dem stromtragfähigen Halbleiterschalter ein Transistor parallel geschaltet ist derart, dass durch kurzzeitige Übernahme des Laststroms des stromtragfähigen Halbleiterschalters dieser zurückgesetzt wird und an die Basis des Transistors eine Reset-Spannung zum Zurücksetzen des stromtragfähigen Halbleiterschalters angelegbar ist, wobei diese Spannung aus einem weiteren Kondensator zur Verfügung gestellt ist, welcher über die Stringpole geladen wird.

2. Anordnung nach Anspruch 1,
**dadurch gekennzeichnet, dass**
eine Fernschalteinrichtung vorhanden ist, welche eine netzunabhängige Stromversorgung und einen Not-Aus-Taster besitzt, weiterhin die Fernschalteinrichtung galvanisch getrennt mit dem Steuereingang des stromtragfähigen Halbleiterschalters verbunden ist.

3. Anordnung nach Anspruch 2,
**dadurch gekennzeichnet, dass**
für die galvanische Trennung ein Optokoppler vorgesehen ist, der ausgangsseitig mit dem Steuereingang des stromtragfähigen Halbleiterschalters in Verbindung steht.

4. Anordnung nach Anspruch 2 oder 3,
**dadurch gekennzeichnet, dass**
die netzunabhängige Stromversorgung eine Solarzelle und einen Speicherkondensator umfasst.

5. Anordnung nach einem der Ansprüche 2 bis 4,
**dadurch gekennzeichnet, dass**
die Fernschalteinrichtung einen Spannungsmesser aufweist, welcher über einen Spannungsteiler mit den Stringpolen in Verbindung steht.

6. Anordnung nach einem der Ansprüche 2 bis 5,
**dadurch gekennzeichnet, dass**
die Elemente der Fernschalteinrichtung in einem gemeinsamen Gehäuse integriert sind.

7. Anordnung nach einem der vorangegangenen Ansprüche,
**dadurch gekennzeichnet, dass**
zwischen der Photovoltaikanlage und dem jeweiligen zugehörigen Wechselrichter ein Lasttrenner geschaltet ist.

8. Anordnung nach Anspruch 1,
**dadurch gekennzeichnet, dass**
der weitere Kondensator über eine spannungsbegrenzende Diode sowie einen Spannungsteiler und eine Freilaufdiode durch Anschluss an die Stringpole geladen wird.
